(19) Europäisches Patentamt
European Patent Office
Office européen des brevets

(11) EP 3 778 426 B1

(12) **EUROPEAN PATENT SPECIFICATION**

(45) Date of publication and mention of the grant of the patent:
**19.11.2025 Bulletin 2025/47**

(21) Application number: **19775738.8**

(22) Date of filing: **01.04.2019**

(51) International Patent Classification (IPC):
***B65D 81/26** (2006.01)* ***B32B 27/00** (2006.01)*
***B65D 65/40** (2006.01)* ***B65D 81/24** (2006.01)*
***B65D 85/67** (2006.01)*

(52) Cooperative Patent Classification (CPC):
**B65D 81/264; B32B 7/06; B32B 7/12; B32B 23/04; B32B 23/08; B32B 27/08; B32B 27/28; B32B 27/281; B32B 27/285; B32B 27/286; B32B 27/288; B32B 27/302; B32B 27/304; B32B 27/306; B32B 27/308;** (Cont.)

(86) International application number:
**PCT/JP2019/014518**

(87) International publication number:
**WO 2019/189931 (03.10.2019 Gazette 2019/40)**

(54) **PACKAGING BODY OF BARRIER FILM FOR ELECTRONIC DEVICE**

VERPACKUNGSKÖRPER EINER SPERRFOLIE FÜR ELEKTRONISCHE VORRICHTUNG

CORPS D'EMBALLAGE D'UN FILM BARRIÈRE DESTINÉ À UN DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2018 JP 2018069256**

(43) Date of publication of application:
**17.02.2021 Bulletin 2021/07**

(73) Proprietor: **Toyo Seikan Group Holdings, Ltd.**
**Shinagawa-ku**
**Tokyo 141-8627 (JP)**

(72) Inventors:
- **SUGIURA, Chiho**
  **Tokyo 141-8627 (JP)**
- **OBU, Yusuke**
  **Tokyo 141-8627 (JP)**
- **HAYASHI, Kenji**
  **Tokyo 141-8627 (JP)**
- **KAWAKUBO, Yutaka**
  **Tokyo 141-8627 (JP)**

(74) Representative: **J A Kemp LLP**
**80 Turnmill Street**
**London EC1M 5QU (GB)**

(56) References cited:
**EP-A1- 3 543 009** **EP-A1- 3 778 212**
**WO-A1-2017/164352** **WO-A1-2017/164352**
**WO-A1-2018/092672** **WO-A1-2019/189805**
**JP-A- 2002 347 713** **JP-A- 2014 019 056**
**JP-A- 2014 019 056** **JP-A- 2014 168 949**
**JP-A- 2015 096 320** **JP-A- H06 278 775**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
**B32B 27/32; B32B 27/325; B32B 27/34; B32B 27/36; B32B 27/365; B32B 27/40; B65D 85/672;** B32B 2255/10; B32B 2255/20; B32B 2255/26; B32B 2255/28; B32B 2307/7244; B32B 2307/726; B32B 2307/7265; B32B 2457/12; B32B 2457/206; B32B 2457/208; B32B 2553/00; H10K 50/844; H10K 50/846

## Description

Technical Field:

This invention relates to a packaged barrier film used as a material for sealing electronic devices such as organic electroluminescent (EL) devices, solar cells and the like.

Background Art:

In order to avoid the leakage of electric charges caused by water, a high degree of water barrier property is required for a variety of kinds of electronic devices that have been developed and put into practical use in recent years, such as organic electroluminescent (organic EL) devices, solar cells, touch panels and electronic papers.
As means for improving properties and, specifically, gas barrier properties of various plastic substrates, there has been known an art of forming a thin inorganic film (inorganic barrier layer) of silicon oxide or the like by vapor deposition on the surfaces of the plastic substrates (patent document 1). The film provided with such a thin inorganic film has been widely used as a barrier film. The barrier film, however, is not sufficient for fulfilling the water barrier property required for the above-mentioned electronic devices.
To satisfy such requirements, furthermore, there has also been proposed a water barrier laminate having a structure on which a water-trapping layer is laminated, the water-trapping layer using a hygroscopic ionic polymer as the matrix (patent document 2).
The water-trapping layer is formed by applying a coating composition for forming the ionic polymer-containing trapping layer on the inorganic barrier layer that is formed on the surface of a plastic film by vapor deposition or the like method, followed by curing. Upon forming the trapping layer, the water-trapping layer exhibits improved water barrier property.
However, the more the barrier film exhibits its improved water barrier property, the more the barrier film tends to absorb the moisture. When put into practical use, therefore, the water-barrier property has already been reduced by the absorption of moisture, and the water-barrier property of the barrier film is liable to extinguish in short periods of time.
The general technical background of the invention also includes Patent document 3, which relates to a film-roll package and its manufacturing method.

Prior Art Documents:

Patent Documents:

Patent document 1: Japanese Patent Laid-Open No. 2000-255579
Patent document 2: Japanese Patent Laid-Open No. 2015-96320
Patent document 3: JP 2014 019056 A

Outline of the Invention:

Problems that the Invention is to Solve:

It is, therefore, an object of the present invention to provide a packaged barrier film for electronic devices, which stably maintains excellent water barrier property inherent in the barrier film without permitting it to be extinguished by the adsorption of moisture.

Means for Solving the Problems:

According to the present invention, there is provided a roll of packaged barrier film comprising a laminate of a barrier film that is used for electronic devices and has a water permeability (23°C, RH50%) that is set to be not more than $10^{-4}$ g/m$^2$/day and a desiccant sheet that is so provided as to cover the one surface of the barrier film, characterized in that:

(a) said desiccant sheet is stuck to the barrier film by using an adhesive agent,
(b) the barrier film is held being wound up like a roll, and
(c) said roll of package is hermetically contained in a packing bag of a metal foil provided with a heat-seal layer.

In the roll of package of the invention, the following embodiments can be preferably employed.

(1) The barrier film has a water content that is maintained to be not more than 2000 ppm;
(2) The adhesive agent has an adhesive force that is not more than 0.3 N/25 mm when adhered to the surface of the barrier film 1 to which the desiccant sheet is stuck;
(3) The barrier film has a multilayer structure including a water-trapping layer;
(4) The barrier film includes a plastic substrate layer and an inorganic barrier layer provided on the substrate layer, and the water-trapping layer is provided on the inorganic barrier layer; and
(5) The desiccant sheet includes a hygroscopic resin layer in which a desiccant is dispersed and a surface protection resin layer formed on one surface of the hygroscopic resin layer, the surface protection resin layer having a water permeability of not more than 40 $g/m^2 \cdot day$ at 40°C and 90%RH, and the other surface of the hygroscopic resin layer being so arranged as to face the barrier film.

Effects of the Invention:

In the roll of package of the invention, the barrier film of which the one surface is covered with the desiccant sheet is a film having an excellent water barrier property and a water permeability (23°C, RH50%) that is set to be not more than $10^{-4}$ $g/m^2/day$. To use it, the desiccant sheet is removed, and the barrier film is used as a material for sealing a variety of kinds of electronic devices. Here, what is particularly important is that the roll of package is in the form of a laminate of a the barrier film and the desiccant sheet, and the barrier film is held being wound up like a roll.
That is, despite the roll of package assumes the layered structure having the desiccant sheet which is so provided as to cover the one surface of the barrier film, the barrier film is held in a state of being sandwiched by the desiccant sheet. Therefore, the water is effectively limited from infiltrating into the barrier film. Besides, even if some water may have been contained in the barrier film, the water is adsorbed by the desiccant sheet. As a result, the roll of package is held in a state where excellent water barrier property of the barrier film is being maintained.
For example, a desiccant sheet was stuck onto the one surface of the barrier film that has been so dried that the water content thereof was not more than 2000 ppm, and the resulting laminate was wound up to obtain a roll of package. The roll of package was then hermetically contained in a packing bag made of a metal foil and was stored in the open air. It was then confirmed that the water content of the barrier film had not been increased even after the passage of several months.
Therefore, when the desiccant sheet is removed and the packaged barrier film is used as a material for sealing the electronic devices, the water content of the barrier film has been maintained to be very low. Accordingly, excellent water barrier property can be exhibited over extended periods of time, and the interior of the device can be stably maintained in the dry state.

Brief Description of the Drawings:

[Fig. 1] It is a schematic view of a layered structure of a roll of packaged barrier film of the invention.
[Fig. 2] It is a schematic side sectional view of the roll of packaged barrier film of the invention.
[Fig. 3] It is a schematic sectional view illustrating a structure of layers of the barrier film in the roll of package of Figs. 1 and 2.
[Fig. 4] It is a schematic sectional view illustrating a structure of layers of a desiccant sheet in the roll of package of Figs. 1 and 2.
[Fig. 5] It is a view illustrating a means for sealing the barrier film.
[Fig. 6] It is a view illustrating another means for sealing the barrier film.

Modes for Carrying Out the Invention:

As shown in Fig. 1, the roll of package of the invention comprises a laminate of a barrier film 1 and a desiccant sheet 3 which is so provided as to cover the one surface of the barrier film 1. Referring to Fig. 2, the laminate is wound up and is held in a hollow or solid roll made of a metal such as stainless steel or a resin with the barrier film 1 on the lower side.
As will be understood from Fig. 2, the roll of package according to the invention assumes the layered structure of the barrier film 1 and the desiccant sheet 3. Despite of this structure, the barrier film 1 is sandwiched by the desiccant sheets 3. Therefore, the water is completely prevented from infiltrating into the barrier film 1 from the exterior. Besides, even if some water is contained in the barrier film 1, the water can be adsorbed by the desiccant sheet 3 and removed. Accordingly, the roll of package can be used as a material for sealing various kinds of electronic devices in a state where it is

allowed to exhibit the water barrier property possessed by the barrier film 1 to a sufficient degree. Therefore, the interior of the electronic devices can be stably maintained in the dry state.

In the invention, furthermore, the barrier film 1 used for the roll of package has a water permeability (23°C, RH50%) that is set to be not more than $10^{-4}$ g/m$^2$/day, preferably, not more than $10^{-5}$ g/m$^2$/day and, more preferably, not more than $10^{-6}$ g/m$^2$/day. Namely, the lower the water permeability is, the higher the water barrier property. In the roll of package of the invention, the barrier film 1 has been effectively prevented from absorbing the water. Therefore, the barrier film 1 exhibits excellent water barrier property depending on its water permeability.

It is, further, desired that the water content of the barrier film 1 has been adjusted to be not more than 2000 ppm and, specifically, not more than 1000 ppm prior to sticking the desiccant sheet 3.

Here, the water content can be easily calculated in compliance with the following formula from a difference between the weight of when the barrier film 1 is maintained in an absolute dry condition and the weight (i.e., water content) of when the barrier film is measured.

$$\text{Water content (\%)} = 100 \times (A-B)/B$$

wherein A is a weight of the barrier film 1 that is measured, and B is a weight of the barrier film 1 of when it is dried by heating.

<Barrier film 1>

According to the present invention, the barrier film 1 of low water permeability described above has a water-trapping layer which basically absorbs and traps the water.

Fig. 3 illustrates a structure of layers of the barrier film that has the water-trapping layer.

Referring to Fig. 3, the barrier film is provided with the water-trapping layer 5 which is formed on an inorganic barrier layer 9 that is formed on the surface of a plastic substrate layer 7.

That is, the above-mentioned low water permeability can be expressed even with a single-layer film consisting of the water-trapping layer 5 alone. However, the material for sealing various electronic devices also requires the oxygen barrier property in addition to the water barrier property in order to prevent the substrates from being deteriorated by oxidation. Usually, therefore, it is desired that the barrier film 1 has a structure that includes the inorganic barrier layer 9 provided on the plastic substrate layer 7, and exhibits the water permeability described above based on the whole layer constitution.

<Water-trapping layer 5>

In the invention, the water-trapping layer 5 works to shut off the water that flows in the direction of thickness of the barrier film 1, and has no specific limitation provided it has the water shut-off property. Namely, the water-trapping layer 5 may be a widely known layer such as the one obtained by dispersing a hygroscopic agent such as zeolite in a predetermined resin layer. However, when a high degree of barrier property against the water is required, e.g., when it is required to set the water permeability (23°C, RH50%) of the barrier film 1 to lie in a preferred range of not more than $10^{-4}$ g/m$^2$/day (or in an optimum range of not more than $10^{-6}$ g/m$^2$/day), it is desired that the water-trapping layer 5 is formed by using an ionic polymer that is disclosed in the Japanese Patent Laid-Open No. 2015-96320. More desirably, the water-trapping layer 5 is formed by using the ionic polymer as the matrix and by dispersing, in the matrix, a hygroscopic agent having an ultimate humidity lower than that of the ionic polymer. Upon using the ionic polymer as the matrix, the water-trapping layer 5 excellently traps the water. When the hygroscopic agent having a lower ultimate humidity is dispersed therein, furthermore, the water-trapping layer 5 can be effectively prevented from being deformed or swollen that results from the absorption of water.

The ionic polymers preferably used for forming the water-trapping layer 5 can be divided into cationic polymers and anionic polymers.

The cationic polymer is a polymer that has, in the molecules thereof, a cationic group that could form a positive electric charge in water, such as primary to tertiary amino groups, quaternary ammonium group, pyridyl group, imidazole group or quaternary pyridinium. With this cationic polymer, the cationic group exhibits a strong nucleophilic action and traps the water by hydrogen bond. Namely, the cationic polymer forms a hygroscopic matrix.

The amount of the cationic groups in the cationic polymer should, usually, be such that the polymer acquires a coefficient of water absorption (JIS K-7209-1984) of not less than 20% and, specifically, 30% to 45% in an atmosphere of a humidity of 80%RH and 30°C.

As the cationic polymer, there can be used at least one of the cationic monomers as represented by amine monomers such as allylamine, ethyleneimine, vinylbenzyltrimethylamine, [4-(4-vinylphenyl)-methyl]-trimethylamine and vinylbenzyltriethylamine; nitrogen-contained heterocyclic monomers such as vinylpyridine and vinylimidazole; and salts

thereof; being suitably polymerized or copolymerized with any other monomers copolymerizable therewith and, further as required, being partly neutralized with an acid.

Such cationic polymers have been closely described in the Japanese Patent Laid-Open No. 2015-96320, etc., and are not repeated here. Usually, however, a polyallylamine is preferably used from the standpoint of forming films.

The anionic polymer, on the other hand, is a polymer that has, in the molecules thereof, an anionic functional group that could form a negative electric charge in water, such as carboxylic acid group, sulfonic acid group, phosphonic acid group, or an acidic base formed by partly neutralizing the above-mentioned groups. With this anionic polymer having such a functional group, the functional group traps the water by hydrogen bond. Namely, the anionic polymer forms a hygroscopic matrix.

Like the case of the above-mentioned cationic polymer, the amount of the anionic functional groups in the anionic polymer should be such that the polymer acquires a coefficient of water absorption (JIS K-7209-1984) of not less than 20% and, specifically, 30% to 45% in an atmosphere of a humidity of 80%RH and 30°C though the amount may vary depending on the kind of the functional group.

As the anionic polymer having the above functional group, there can be used at least one of the anionic monomers as represented by carboxylic acid monomers such as methacrylic acid, acrylic acid, and maleic anhydride; sulfonic acid monomers such as $\alpha$-halogenated vinylsulfonic acid, styrenesulfonic acid and vinylsulfonic acid; phosphonic acid monomers such as vinylphosphoric acid, etc.; and salts of these monomers; being suitably polymerized or copolymerized with any other monomers copolymerizable therewith and, further as required, being partly neutralized with an alkali.

Such anionic polymers, too, have been closely described in the Japanese Patent Laid-Open No. 2015-96320, etc., and are not repeated here. Usually, however, there is preferably used a poly(meth)acrylic acid or a partly neutralized product thereof (e.g., the product thereof which is partly an Na salt) .

As the hygroscopic agent which, upon being contained in the ionic polymer, works to prevent the deformation caused by swelling, i.e., as the hygroscopic agent having an ultimate humidity lower than that of the ionic polymer, there can be exemplified those that have ultimate humidities of not more than 6% under an environmental condition of a humidity of 80%RH and a temperature of 30°C. Namely, when the hygroscopic agent has an ultimate humidity higher than that of the ionic polymer, the water absorbed by the matrix cannot be confined therein sufficiently but may be released. On the other hand, when the ionic polymer is blended with the hygroscopic agent having an ultimate humidity lower than that of the ionic polymer, the water can be effectively trapped even in an atmosphere of a low humidity and, besides, the water absorbed by the ionic polymer can also be trapped by the hygroscopic agent. Thus the ionic polymer exhibits a high degree of water barrier property suppressing the release of water.

The above hygroscopic agents, in general, have coefficients of water absorption (JIS K-7209-1984) of not less than 50% in an atmosphere of a humidity of 80%RH and a temperature of 30°C, and include those of the inorganic type and those of the organic type.

As the inorganic hygroscopic agent, there can be exemplified clay minerals such as zeolite, alumina, active carbon and montmorillonite as well as silica gel, calcium oxide and magnesium sulfate.

As the organic hygroscopic agent, there can be exemplified an anionic polymer or a crosslinked product of a partly neutralized product thereof. As the anionic polymer, there can be exemplified at least one of the anionic monomers as represented by carboxylic acid monomers ((meth) acrylic acid, maleic anhydride, etc.), sulfonic acid monomers (halogenated vinylsulfonic acid, styrenesulfonic acid, vinylsulfonic acid, etc.), phosphonic acid monomers (vinylphosphoric acid, etc.), and salts of those monomers, which is polymerized or copolymerized with any other monomers. In the use where transparency is required, in particular, an organic hygroscopic agent is effectively used. For instance, a crosslinked sodium poly(meth)acrylate in a fine granular form serves as a representative organic hygroscopic agent.

Among the above hygroscopic agents, a hygroscopic agent having a small grain size (e.g., having a mean primary grain size of not more than 100 nm and, specifically, not more than 80 nm) is preferred and, specifically, a hygroscopic agent of an organic polymer having a small grain size is most desired from the standpoint of realizing a large specific surface area and a high hygroscopic property.

That is, the hygroscopic agent of the organic polymer disperses very favorably and homogeneously in the matrix of the ionic polymer. Besides, upon employing the emulsion polymerization or the suspension polymerization as a polymerization method for its production, the hygroscopic agent of the organic polymer can be obtained in a granular form maintaining a fine and uniform spherical shape. By containing the hygroscopic agent in amounts larger than a certain ratio, therefore, there can be secured a very high degree of transparency.

The organic fine granular hygroscopic agent has a very low ultimate humidity as described above and exhibits a high hygroscopic property and besides, upon being crosslinked, shows a very decreased change in the volume caused by swelling. Therefore, the organic fine granular hygroscopic agent is best suited for lowering the humidity in the environmental atmosphere down to the absolute dry condition or down to nearly the absolute dry condition yet suppressing a change in the volume thereof.

As the organic fine granular hygroscopic agent, a crosslinked fine granular sodium polyacrylate (mean grain size

of about 70 nm) has been placed in the market by Toyobo K.K. in the form of a colloidal dispersion solution (pH = 10.4) and in the trade name of TAFTIC HU-820E.

In the invention, the amount of the hygroscopic agent is set depending on the kind of the ionic polymer from the standpoint of enabling its properties to be exhibited to a full extent, improving the water barrier property to a striking degree and effectively suppressing a change in the size caused by the swelling and, further, securing the water barrier property superior to the barrier property of the inorganic barrier layer 9 for extended periods of time.

For example, when the water-trapping layer 5 is to be formed by dispersing the hygroscopic agent in the cationic polymer, it is desired that the hygroscopic agent is made present in an amount of, usually, not less than 50 parts by mass, specifically, 100 to 900 parts by mass and, more specifically, 200 to 600 parts by mass per 100 parts by mass of the cationic polymer. Further, when dispersed in the anionic polymer, it is desired that the hygroscopic agent is made present therein in an amount of not less than 50 parts by mass, specifically, 100 to 1300 parts by mass and, more specifically, 150 to 1200 parts by mass per 100 parts by mass of the anionic polymer.

In the water-trapping layer 5 formed by using the ionic polymer, furthermore, it is desired that a crosslinked structure has been introduced into the ionic polymer. That is, with the crosslinked structure being introduced into the ionic polymer, when the water is absorbed, the molecules of the ionic polymer are locked by each other since they have been crosslinked, therefore, working to suppress a change in the volume caused by the swelling (absorption of water) and contributing to improving the mechanical strength and dimensional stability.

The crosslinked structure can be introduced by adding a crosslinking agent into a coating composition for forming the water-trapping layer 5. Specifically, unlike the cationic polymer, the anionic polymer traps the water relying only upon the hydrogen bond. By introducing a spatial mesh structure (crosslinked structure) suited for absorbing the moisture into the matrix, therefore, the hygroscopic property can be improved to a large extent.

The crosslinking agent for introducing the crosslinked structure may differ to some extent depending on when the crosslinked structure is to be introduced into the cationic polymer and when the crosslinked structure is to be introduced into the anionic polymer.

As the crosslinking agent for the cationic polymer as also described in, for example, the Japanese Patent Laid-Open No. 2015-96320, there can be used a compound having a crosslinking functional group (e.g., epoxy group) capable of reacting with a cationic group and a functional group (e.g., alkoxysilyl group) capable of forming a siloxane structure in the crosslinked structure through the hydrolysis and dehydration ·condensation. Concretely, there can be preferably used a silane compound represented by the following formula (1):

$$X\text{-}SiR^1_n(OR^2)_{3-n} \qquad (1)$$

wherein X is an organic group having an epoxy group at a terminal thereof, $R^1$ and $R^2$ are, respectively, methyl groups, ethyl groups or isopropyl groups, and n is 0, 1 or 2.

The silane compound has, as functional groups, the epoxy group and the alkoxysilyl group, and the epoxy group undergoes the addition reaction with a functional group (e.g., $NH_2$) of the cationic polymer. The alkoxysilyl group, on the other hand, forms a silanol group (SiOH group) through the hydrolysis, grows by forming a siloxane structure through the condensation reaction and, finally, forms a crosslinked structure among the cationic polymer chains. Thus the crosslinked structure having a siloxane structure is introduced into the matrix of the cationic polymer.

Besides, the cationic polymer is alkaline. As a result, when the coating composition containing the cationic polymer is applied to form the water-trapping layer 5, the addition reaction is accelerated between the cationic group and the epoxy group and, also, the dehydration·condensation are accelerated among the silanol groups enabling the crosslinked structure to be easily introduced.

In the invention, the organic group X having an epoxy group in the above-mentioned formula (1) can be represented by a $\gamma$

- glycidoxyalkyl group. For example, a $\gamma$
- glycidoxypropyltrimethoxysilane or a $\gamma$
- glycidoxypropylmethyldimethoxysilane can be preferably used as the crosslinking agent.

As the crosslinking agent, there can also be preferably used a compound whose epoxy group in the above formula (1) is an alicyclic epoxy group such as epoxycyclohexyl group. For example, when a compound having an alicyclic epoxy group such as $\beta$-(3,4-epoxycyclohexyl)ethyltrimethoxysilane is used as the crosslinking agent, an alicyclic structure is introduced together with the siloxane structure into the crosslinked structure of the matrix. Introduction of such an alicyclic structure helps further effectively exhibit the function of the matrix which is to form a spatial mesh structure adapted to absorbing the moisture.

In order to introduce the alicyclic structure into the crosslinked structure, furthermore, there can be used, as the crosslinking agent, a compound having a plurality of epoxy groups and alicyclic groups, e.g., a diglycidyl ester represented

by the following formula (2):

G-O(C=O)-A-(C=O)O-G (2)

wherein G is a glycidyl group, and A is a divalent hydrocarbon group having an aliphatic ring, such as cycloalkylene group. A representative diglycidyl ester is expressed by the following formula (2-1).

[Chemical 1]

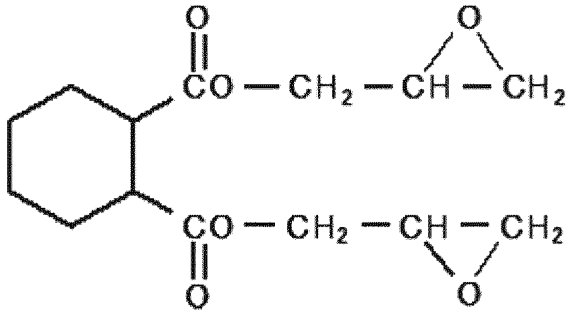

(2-1)

That is, the diglycidyl ester of the formula (2) has no alkoxysilyl group but works to introduce the alicyclic structure into the crosslinked structure. Therefore, the diglycidyl ester of the formula (2) is effective in forming, in the matrix, a spatial mesh structure that is adapted to absorbing the moisture.

It is desired that the above-mentioned crosslinking agent is used in an amount of 5 to 60 parts by mass and, specifically, 15 to 50 parts by mass per 100 parts by mass of the cationic polymer. It is also desired that at least not less than 70% by mass and, preferably, not less than 80% by mass of the crosslinking agent is the silane compound represented by the above-mentioned formula (1).

As the crosslinking agent for introducing the crosslinked structure into the anionic polymer, furthermore, there can be used a compound having not less than two crosslinkable functional groups (e.g., epoxy groups) that can react with the ionic groups possessed by the ionic polymer as described, say, in the Japanese Patent Laid-Open No. 2015-96320. Namely, there can be desirably used a diglycidyl ester represented by the above formula (2):

G-O(C=O)-A-(C=O)O-G (2)

wherein G is a glycidyl group, and A is a divalent hydrocarbon group having an aliphatic ring, such as cycloalkylene group, that was exemplified above for the coating composition for forming the cationic matrix.

In the diglycidyl ester of the above formula (2), the epoxy group reacts with the anionic group, and the matrix forms therein the crosslinked structure that includes an alicyclic structure formed by the divalent group A. The crosslinked structure that includes the above alicyclic structure helps suppress the swelling.

Among the above-mentioned diglycidyl esters, what are preferred have been exemplified above already. In particular, from the standpoint of forming a spatial mesh structure that is adapted to absorbing the moisture, it is most desired to use the diglycidyl ester represented by the above-mentioned formula (2-1).

The crosslinking agent for the anionic polymer is used in an amount of, desirably, 1 to 50 parts by mass and, specifically, 10 to 40 parts by mass per 100 parts by mass of the anionic polymer.

<Plastic substrate layer 7>

The plastic substrate layer 7 lies under the inorganic barrier layer 9 that will be described later, and is, usually, formed by using a thermoplastic or thermosetting resin by such a method as injection or co-injection forming, extrusion or co-extrusion forming, film- or sheet-forming method, compression forming method or cast polymerization method depending on the form of the resin.

Usually, the thermoplastic resin is preferred from the standpoint of formability and cost.

As the thermoplastic resin, there can be exemplified polyolefins such as low-density polyethylene, high-density polyethylene, polypropylene, poly 1-butene, poly 4-methyl-1-pentene and random or block copolymers of $\alpha$-olefins (such as ethylene, propylene, 1-butene, and 4-methyl-1-pentene) ; cyclic olefin resins such as cyclic olefin copolymer and cyclic olefin polymer; ethylene·vinyl compound copolymers such as ethylene·vinyl acetate copolymer, ethylene ·vinyl alcohol copolymer and ethylene·vinyl chloride copolymer; styrene resins such as polystyrene, acrylonitril ·stylene copolymer, ABS, and $\alpha$-methylstyrene·styrene copolymer; polyvinyl compounds such as polyvinyl chloride, polyvinylidene chloride,

vinyl chloride·vinylidene chloride copolymer, methyl polyacrylate and methyl polymethacrylate; polyamides such as nylon 6, nylon 6-6, nylon 6-10, nylon 11 and nylon 12; thermoplastic polyesters such as polyethylene terephthalate (PET), polybutylene terephthalate and polyethylene naphthalate (PEN); polycarbonate; polyphenylene oxide; as well as polyimide resin, polyamideimide resin, polyetherimide resin, fluorine-contained resin, allyl resin, polyurethane resin, cellulose resin, polysulfone resin, polyethersulfone resin, ketone resin, amino resin and biodegradable resins such as polylactic acid. There can be further used a blend thereof or the above resins that are suitably modified upon being copolymerized (e.g., acid-modified olefin resin, etc.).

It is, further, desired that the substrate layer 7 is formed by using a gas barrier resin having excellent oxygen barrier property, such as ethylene- vinyl alcohol copolymer. Or the substrate layer 7 may have a multilayered structure that includes a layer formed by using the gas barrier resin.

In the invention, it is more preferred to use, as the substrate layer 7, a film of a polyester resin such as polyethylene terephthalate (PET); a film of a polyimide resin; or a film of a cyclic olefin resin such as cyclic olefin copolymer or cyclic olefin polymer from such standpoints as easy availability, cost, formability, barrier property against the oxygen to some extent, and as being suited to be formed under the inorganic barrier layer 9 that will be described later.

There is no specific limitation on the thickness of the plastic substrate layer 7. If the thickness is too large, however, the barrier film 1 acquires an increased water permeability, and it may become difficult to satisfy the above-mentioned water permeability. Therefore, the thickness of the substrate layer 7 is, usually, set to be not more than 200 $\mu$m and, preferably, in a range of not more than 125 $\mu$m in which the water permeability of the barrier film 1 can be set to lie within the above-mentioned range.

<Inorganic barrier layer 9>

The inorganic barrier layer 9 is formed on the plastic substrate layer 7 which serves as an underlying layer, and may be a layer that has been widely known as taught in, for example, Japanese Patent Laid-Open No. 2015-96320. From the standpoint of securing a high degree of oxygen barrier property, the inorganic barrier layer 9 should, preferably, be an inorganic film deposited by a physical vapor deposition such as sputtering, vacuum vapor deposition or ion plating, or by a chemical vapor deposition such as plasma CVD, and should, for example, be a film formed by using various kinds of metals or metal oxides. Specifically, the inorganic barrier layer 9 should, preferably, be the one formed by the plasma CVD from the standpoint of being uniformly formed even on rugged surfaces yet exhibiting excellent barrier property against not only the oxygen but also the water.

Here, to form the film by the plasma CVD, the plastic substrate layer 7 of the form of a film that lies under the inorganic barrier layer 9 is arranged in a plasma treatment chamber that is maintained at a predetermined degree of vacuum, a gas (reaction gas) of a metal or a compound of the metal for forming the film and an oxidizing gas (usually oxygen gas or NOx gas) are fed together with a suitable carrier gas such as argon or helium, through gas feed pipes, into the plasma treatment chamber which is shielded with a metal wall and in which the pressure is reduced to a predetermined decree of vacuum, a glow discharge is generated in this state in a microwave electric field or a high-frequency electric field, a plasma is generated by utilizing the electric energy thereof, and a product decomposed from the compound is deposited on the surface of the plastic substrate layer 7 thereby to form the film.

As the reaction gas, in general, there can be preferably used a gas of an organometal compound from the standpoint of forming a film that includes a flexible resin containing carbon on the surface of the underlying substrate layer 7 and a highly oxidized region having a high degree of barrier property thereon. For example, it is desired to use a gas of an organoaluminum compound such as trialkylaluminum, or a gas of an organotitanium compound, an organozirconium compound or an organosilicon compound. Specifically, it is most desired to use the organosilicon compound from the standpoint of relatively easily and efficiently forming the inorganic barrier layer 9 that has a high degree of barrier property against oxygen.

As the organosilicon compound, there can be exemplified organosilane compounds such as hexamethyldisilane, vinyltrimethylsilane, methylsilane, dimethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane and methyltriethoxysilane, as well as organosiloxane compounds such as octamethylcyclotetrasiloxane, 1,1,3,3-tetramethyldisiloxane and hexamethyldisiloxane. There can be, further, used aminosilane and silazane in addition to them.

The above-mentioned organometal compounds can be used alone or in a combination of two or more kinds.

The thickness of the inorganic barrier layer 9 may be set depending on the thickness of the plastic substrate layer 7 so as to satisfy the above-mentioned water permeability. Usually, the inorganic barrier layer 9 may have a thickness of 4 to 500 nm and, specifically, about 30 to about 400 nm.

The above-mentioned inorganic barrier layer 9 can also be formed on the plastic substrate layer 7 by a coating method instead of such means as vapor deposition. That is, the inorganic barrier layer 9 formed by the coating method has the oxygen barrier property lower than that of the inorganic barrier layer formed by the vapor deposition. Depending upon

the required degree of barrier property against oxygen, however, the inorganic barrier layer 9 formed by the coating method will suffice for the need.

As for forming the inorganic barrier layer 9 by the coating method, a representative example comprises preparing an organic solvent solution which contains a polysilazane or a polycondensable silane compound (e.g., alkoxysilane, etc.) and a polycondensable alumina compound (e.g., alkoxyaluminum, etc.) as film-forming components and, further, contains inorganic fine particles such as of silica or alumina, applying the organic solvent solution onto a predetermined surface followed by heating thereby to volatilize the organic solvent and thus to form the film.

The barrier film 1 of the above-mentioned layer structure is obtained by, for example, preparing in advance a laminated film comprising the plastic substrate layer 7 on which the inorganic barrier layer 9 is formed, and then forming a water-trapping layer 5 on the inorganic barrier layer that is formed on the laminated film.

To form the water-trapping layer 5, a coating composition is prepared by dissolving or dispersing a predetermined hygroscopic polymer or a desiccant in an organic solvent, and is applied followed by heating to form a layer thereof. The layer is then held in a dry atmosphere under a reduced pressure to let the water present in the layer released. It is also possible to apply the above coating composition on another organic film thereby to similarly form the water-trapping layer 5. Thereafter, by using an adhesive for dry lamination, the water-trapping layer 5 is adhered onto the inorganic barrier layer 9 formed on the laminate film. In this case, on the water-trapping layer 5 shown in Fig. 3, there is formed, as an organic layer, a film that serves as the underlying layer when the water-trapping layer 5 is to be formed, and an adhesive layer is interposed between the inorganic barrier layer 9 and the water-trapping layer 5.

In the invention as described already, the barrier film 1 has a water permeability that is set to lie within a predetermined very narrow range. That is, to set the water permeability to lie within the predetermined range, the layer structure needs not be limited to the one shown in Fig. 3 above but may be a layer structure in which, for example, the inorganic barrier layer 9 and the water-trapping layer 5 are each formed in a plurality of number. Such a structure is obtained by using an adhesive for dry lamination, and by adhering the laminate (barrier film 1) having the layer structure shown in Fig. 3 in a plural number one upon the other.

The water-trapping layer 5 of the barrier film 1 is held in an absolute dry state by drying under reduced pressure, for example, every time when the water-trapping layer 5 is formed. Moreover, the barrier film 1 finally prepared is heated in a heating oven or the like to adjust the water content as desired.

<Desiccant sheet 3>

As the desiccant sheet 3 used for forming the roll of package of the invention, there can be used the known one that is obtained by dispersing a desiccant such as silica gel or the like in a resin. It is, however, desired that the desiccant sheet 3 has a structure as shown in Fig. 4 so that it exhibits the hygroscopic property more reliably.

In Fig. 4, the desiccant sheet 3 includes a hygroscopic resin layer 11 and a surface protection resin layer 13 provided on one surface of the hygroscopic resin layer 11. The other surface of the hygroscopic resin layer 11 (surface thereof on the side where the surface protection resin layer 13 is not provided) serves as a hygroscopically working surface 15 which is to be stuck to the barrier film 1.

In the desiccant sheet 3, the hygroscopic resin layer 11 is a resin layer in which the desiccant is dispersed. As the desiccant, there can be used an inorganic or organic desiccant that has been known per se.

As the inorganic desiccant, there can be exemplified clay minerals such as zeolite, alumina, active carbon and montmorillonite, as well as silica gel, calcium oxide, barium oxide, calcium chloride and magnesium sulfate.

As the organic desiccant, there can be exemplified an anionic polymer or a crosslinked product of a partly neutralized product thereof. As the anionic polymer, there can be exemplified carboxylic acid monomers ((meth)acrylic acid, maleic anhydride, etc.), sulfonic acid monomers (halogenated vinylsulfonic acid, styrenesulfonic acid, vinylsulfonic acid, etc.), phosphonic acid monomers (vinylphosphoric acid, etc.), as well as at least one of the anionic monomers represented by the salts of these monomers, being polymerized or copolymerized with other monomers.

In the invention, from the standpoint of effectively trapping the water released from the barrier film 1, it is more preferred to use a desiccant that exhibits chemical adsorption based on the reaction with the water, such as calcium oxide than to use a desiccant that traps the water based on the physical adsorption, such as zeolite or silica gel.

It is, further, desired that the desiccant has a small grain size from such a standpoint that it can be homogeneously dispersed in the resin and that it has a large specific surface area. It is desired that the desiccant has a mean primary grain size (D50) of not more than 20 $\mu$m calculated as volume as measured, for example, by the laser diffraction·light scattering method. Usually, it is desired that the desiccant is dispersed in the hygroscopic resin layer 11 in an amount of 5 to 80 parts by mass per 100 parts by mass of the resin which is the matrix.

As the resin which is the matrix in the hygroscopic resin layer 11, there can be used any known thermoplastic resin without any particular limitation. Usually, however, there is preferably used an olefin resin such as low-density polyethylene, high-density polyethylene, polypropylene, poly 1-butene, poly 4-methyl-1-pentne or a random or block copolymer of $\alpha$-olefins (such as ethylene, propylene, 1-butene or 4-methyl-1-pentene);or a cyclic olefin copolymer from

the standpoint of stickiness to the surface protection resin layer 13 that will be described later or the barrier film 1 and cost.

Among the above olefin resins, the present invention preferably uses a low-density polyethylene (LDPE), a linear low-density polyethylene (LLDPE), a polypropylene (PP) or a blend thereof and, specifically, the low-density polyethylene (LDPE) or the linear low-density polyethylene (LLDPE) from the standpoint of specifically low hygroscopic property, effectively preventing the release of water from the hygroscopic resin layer 11 and preventing the desiccant from losing its activity prior to its use.

The surface protection resin layer 13 is a layer that prevents the water from infiltrating into the hygroscopic resin layer 11 from the atmosphere. To secure such a water-barrier property, the surface protection resin layer 13 must have a water permeability at 40°C, 90%RH of not more than 40 $g/m^2 \cdot day$ and, specifically, not more than 20 $g/m^2 \cdot day$. If the water permeability is high, the hygroscopic property of the desiccant in the hygroscopic resin layer 11 is spoiled in short periods of time due to the infiltration of water from the atmosphere during the steps of production before executing the drying treatment that will be described later or during the step of handling the materials.

There is no specific limitation on the resin that is used for forming the surface protection resin layer 13 provided it is capable of securing the water permeability mentioned above. From the standpoint of satisfying the water permeability despite of a small thickness, however, it is desired to use the olefin resin that is used for forming the hygroscopic resin layer 11, or the thermoplastic polyester such as polyethylene terephthalate (PET), polybutylene terephthalate or polyethylene naphthalate (PEN). More desirably, there can be used the olefin resin. From the standpoint of attaining a favorable adhesion to the hygroscopic resin layer 11, it is most desired to use the ethylene resin or the propylene resin.

Upon forming the surface protection resin layer 13 by using the above-mentioned resin, the predetermined water permeability can be satisfied with a thickness of, for example, not more than 40 $\mu$m and, specifically, not more than 30 $\mu$m.

With the desiccant sheet 3 used by the present invention as will be understood from the foregoing description, the surface protection resin layer 13 prevents the water from infiltrating into the hygroscopic resin layer 11 from the atmosphere. Besides, the other surface of the hygroscopic resin layer 11 serves as the hygroscopically working surface 15. Namely, the water infiltrating through the surface 15 is trapped by the desiccant.

The roll of package of the invention is obtained by sticking the hygroscopically working surface 15 of the desiccant sheet 3 onto the barrier film 1, and by being wound up on a roller 50 as shown in Fig. 2.

The desiccant sheet 3 is stuck to the barrier film 1 by using an adhesive to reliably prevent inconveniences such as removal, etc. during the storage and transport.

Being stuck to the barrier film 1 by using the adhesive, an adhesive layer is formed between the hygroscopically working surface 15 and the barrier film 1. Here, however, the adhesive layer (not shown in Figs. 1 and 2) should not impair the hygroscopic property of the hygroscopically working surface 15. Accordingly, it is necessary that the adhesive layer has a water permeability larger than that of the above-mentioned surface protection resin layer 13 and, desirably, has a water permeability at, for example, 40°C, 90%RH of not less than 40 $g/m^2 \cdot day$ and, specifically, not less than 60 $g/m^2 \cdot day$.

As the adhesive agent, there can be used a known adhesive agent such as (meth) acrylic adhesive agent or urethane adhesive agent, or a pressure sensitive adhesive agent. By using these adhesive agents, there should be formed an adhesive layer in a thickness of not more than a predetermined value (e.g., not more than 30 $\mu$m) so as to secure the water permeability described above.

It is also allowable to use, as the adhesive agent, an ethylene·vinyl acetate copolymer (EVA), a soft polyolefin (LLDPE) and a metallocene polyolefin elastomer.

It is, further, desired that the adhesive agent has an adhesive force that is so adjusted as to be not more than 0.3 N/25 mm when adhered to the surface of the barrier film 1 to which the desiccant sheet 3 is to be stuck. This is because if the adhesive force is too large, then the surface of the barrier film 1 (e.g., surface of the water-trapping layer 5) may be damaged when the desiccant sheet 3 is removed.

The adhesive force can be adjusted by either introducing a crosslinked structure into high molecules forming the adhesive agent or by adding a lubricant or the like into the adhesive agent depending on the material of the surface of the barrier film 1 to which the desiccant sheet 3 is to be stuck.

The above-mentioned desiccant sheet 3 can be easily formed by, for example, coextruding the desiccant-containing resin composition for forming the hygroscopic resin layer 11 and the resin for forming the surface protection resin layer 13. The desiccant sheet 3 is formed by applying the adhesive agent by using a roll onto the surface of the hygroscopic resin layer 11 that is formed as described above, or by applying an adhesive agent-coating composition containing a solvent followed by drying to a suitable extent. The desiccant sheet 3 can also be formed by coextruding three layers inclusive of the layer of the resin used as the adhesive agent.

In the invention, the roll of package is hermetically contained in a packing bag of a metal foil provided with a heat-seal layer.

Thus, the roll of packaged barrier film 1 can be stored in a state of being wound up on the roll 50 and being hermetically contained in a pouch or the like made of a film that has a heat-seal layer formed on the surface of a metal foil such as aluminum foil.

The roll of package can also be stored in a form of being pulled out of the roll 50. In this case, the roll of package

pulled out of the roll 50 can also be stored being hermetically contained in a bag made of a film that has a heat-seal layer formed on the surface of a metal foil such as aluminum foil. The roll of package can further be hermetically contained in the bag in which no air is contained so the water in the atmosphere will not be adsorbed. This is based on an idea that in case the bag is damaged and no longer maintains the hermetically sealed condition, then this fact can be confirmed from its appearance.

Moreover, the barrier film 1 that is wound up like a roll can be hermetically sealed by a means described below.

As shown, for example, in Fig. 5, a cylindrical metal foil (e.g., aluminum pouch member) 51 forming a heat-seal layer on one surface thereof is so provided as to cover the whole hollow roll (hereinafter, core roll) 50. Next, the desiccant sheet 3 is wound round the cylindrical metal foil 51. The desiccant sheet 3 also works as a blank holder for the cylindrical metal foil 51.

Next, the barrier film 1 is wound round the desiccant sheet 3.

Thereafter, another cylindrical metal foil (e.g., aluminum pouch member) 53 forming a heat-seal layer on one surface thereof is so provided as to cover the desiccant sheet 3. In this case, the cylindrical metal foils 51 and 53 are in such a positional relationship that their respective heat-seal layers are facing each other.

The desiccant sheet 3 is thus covered with the cylindrical metal foil 53. Thereafter, the cylindrical metal foil 53 is melt-adhered to the side surfaces of the desiccant sheet 3 and to the side surfaces of the barrier film 1 and, at the same time, is also melt-adhered to the cylindrical metal foil 51 on the core side followed, finally, by the deaeration sealing. The barrier film 1 is thus completely sealed and stored in a state of being closely adhered to the desiccant sheet 3.

The barrier film 1 is stored in a state where the hollow space of the core roll 50 has not been closed, and there occurs no problem at the time of transport or the like.

According to a means shown in Fig. 6 which is another example, the cylindrical metal foil 51 described above is inserted in the hollow portion of the core roll 50. Thereafter, the desiccant sheet 3 which is wound in a multiplicity of times on itself is inserted in between the inner surface of the core roll 50 and the cylindrical metal foil 51. This eliminates a step on the surfaces of the cylindrical metal foil 51, and removes the water from between the cylindrical metal foil 51 and the core roll 50.

In this case, it is also allowable to wind the desiccant sheet 3 in a multiplicity of layers on the cylindrical metal foil 51 and, thereafter, insert it in the hollow portion of the core roll 50.

Next, as required, the desiccant sheet 3 is wound on the outer surface of the core roll 50 and then the barrier film 1 is wound thereon. Moreover, the cylindrical metal foil 53 is put thereon and is melt-adhered to the side surfaces of the barrier film 1 and to the cylindrical metal foil 51 followed, finally, by the deaeration sealing.

The barrier film 1 is thus hermetically stored in the dry atmosphere.

According to the present invention, owing to the layered structure of the barrier film 1 and the desiccant sheet 3, the water content of the barrier film 1 having a low water permeability can be maintained to be in a dry state or in a range close to the dry state. Therefore, the barrier film 1 is allowed to exhibit its excellent water barrier property over extended periods of time. Therefore, the barrier film 1 removed from the desiccant sheet 3 can be used as a material for sealing various kinds of electronic devices or organic devices that must avoid the leakage of electric charges caused by water, such as organic EL element solar cells, touch panels and electronic panels to maintain the interior of the devices in the dry state.

Description of Reference Numerals:

1: barrier film
3: desiccant sheet
5: water-trapping layer
7: plastic substrate layer
9: inorganic barrier layer
11: hygroscopic resin layer
13: surface protection resin layer
15: hygroscopically working surface
50: roll

## Claims

1. A roll of packaged barrier film comprising a laminate of a barrier film that is used for electronic devices and has a water permeability (23°C, RH50%) that is set to be not more than $10^{-4}$ g/m$^2$/day and a desiccant sheet that is so provided as to cover the one surface of said barrier film, **characterized in that**:

(a) said desiccant sheet is stuck to the barrier film by using an adhesive agent,
(b) said barrier film is held being wound up like a roll, and
(c) said roll of package is hermetically contained in a packing bag of a metal foil provided with a heat-seal layer.

**2.** The roll of package according to claim 1, wherein said barrier film has a water content that is maintained to be not more than 2000 ppm.

**3.** The roll of package according to claim 1, wherein said adhesive agent has an adhesive force that is not more than 0.3 N/25 mm when adhered to the surface of the barrier film 1 to which the desiccant sheet is stuck.

**4.** The roll of package according to claim 1, wherein said barrier film has a multilayer structure including a water-trapping layer.

**5.** The roll of package according to claim 4, wherein said barrier film includes a plastic substrate layer and an inorganic barrier layer provided on said substrate layer, and said water-trapping layer is provided on said inorganic barrier layer.

**6.** The roll of package according to claim 1, wherein said desiccant sheet includes a hygroscopic resin layer in which a desiccant is dispersed and a surface protection resin layer formed on one surface of said hygroscopic resin layer, said surface protection resin layer having a water permeability of not more than 40 g/m$^2$/day at 40°C and 90%RH, and the other surface of said hygroscopic resin layer being so arranged as to face said barrier film.

## Patentansprüche

**1.** Rolle einer verpackten Sperrschutzfolie, umfassend ein Laminat aus einer Sperrschutzfolie, die für elektronische Vorrichtungen verwendet wird und eine Wasserdurchlässigkeit (23 °C, RH50 %) aufweist, die eingestellt ist, um nicht mehr als $10^{-4}$ g/m$^2$/Tag zu sein, und eine Trockenmittellage, die bereitgestellt ist, um die eine Oberfläche der Sperrschutzfolie zu bedecken, **dadurch gekennzeichnet, dass**:

(a) die Trockenmittellage durch Verwenden eines Klebemittels auf die Sperrschutzfolie geklebt wird,
(b) die Sperrschutzfolie wie eine Rolle aufgewickelt gehalten wird, und
(c) die Verpackungsrolle hermetisch in einem Verpackungsbeutel aus einer Metallfolie enthalten ist, die mit einer Heißsiegelschicht versehen ist.

**2.** Verpackungsrolle nach Anspruch 1, wobei die Sperrschutzfolie einen Wassergehalt aufweist, der gehalten wird, um nicht mehr als 2000 ppm zu sein.

**3.** Verpackungsrolle nach Anspruch 1, wobei das Klebemittel eine Klebkraft aufweist, die nicht mehr als 0,3 N/25 mm beträgt, wenn es an der Oberfläche der Sperrschutzfolie 1 haftet, an die die Trockenmittellage geklebt ist.

**4.** Verpackungsrolle nach Anspruch 1, wobei die Sperrschutzfolie eine mehrschichtige Struktur aufweist, die eine Wasser einschließende Schicht beinhaltet.

**5.** Verpackungsrolle nach Anspruch 4, wobei die Sperrschutzfolie eine Kunststoffsubstratschicht und eine auf der Substratschicht bereitgestellte anorganische Sperrschutzschicht enthält, und die Wasser einschließende Schicht auf der anorganischen Sperrschutzschicht bereitgestellt ist

**6.** Verpackungsrolle nach Anspruch 1, wobei die Trockenmittelfolie eine hygroskopische Harzschicht, in der ein Trockenmittel dispergiert ist, und eine Oberflächenschutzharzschicht beinhaltet, die auf einer Oberfläche der hygroskopischen Harzschicht ausgebildet ist, wobei die Oberflächenschutzharzschicht eine Wasserdurchlässigkeit von nicht mehr als 40 g/m$^2$/Tag bei 40 °C und 90 % RH aufweist, und die andere Oberfläche der hygroskopischen Harzschicht angeordnet ist, um der Sperrschutzfolie zugewandt zu sein.

## Revendications

**1.** Rouleau de film barrière emballé comprenant un stratifié d'un film barrière qui est utilisé pour des dispositifs électroniques et présente une perméabilité à l'eau (23 °C, HR 50 %) qui est établie à une valeur inférieure ou égale

à $10^{-4}$ g/m$^2$/jour et une feuille déshydratante disposée de manière à recouvrir une surface dudit film barrière, **caractérisé en ce que** :

(a) ladite feuille déshydratante est collée au film barrière à l'aide d'un agent adhésif,
(b) ledit film barrière est maintenu enroulé comme un rouleau, et
(c) ledit rouleau d'emballage est contenu hermétiquement dans un sac d'emballage fait d'une feuille en métal pourvue d'une couche thermoscellable.

**2.** Rouleau d'emballage selon la revendication 1, dans lequel ledit film barrière présente une teneur en eau qui est maintenue pour être inférieure ou égale à 2000 ppm.

**3.** Rouleau d'emballage selon la revendication 1, dans lequel ledit agent adhésif présente une force adhésive inférieure ou égale à 0,3 N/25 mm lorsqu'il est mis à adhérer à la surface du film barrière 1 sur laquelle est collée la feuille déshydratante.

**4.** Rouleau d'emballage selon la revendication 1, dans lequel ledit film barrière présente une structure multicouche incluant une couche de piégeage d'eau.

**5.** Rouleau d'emballage selon la revendication 4, dans lequel ledit film barrière inclut une couche de substrat en plastique et une couche barrière inorganique disposée sur ladite couche de substrat, et ladite couche de piégeage d'eau est disposée sur ladite couche barrière inorganique.

**6.** Rouleau d'emballage selon la revendication 1, dans lequel ladite feuille déshydratante inclut une couche de résine hygroscopique dans laquelle un déshydratant est dispersé et une couche de résine de protection de surface formée sur une surface de ladite couche de résine hygroscopique, ladite couche de résine de protection de surface présentant une perméabilité à l'eau inférieure ou égale à 40 g/m$^2$/jour à 40 °C et 90 % HR, et l'autre surface de ladite couche de résine hygroscopique étant agencée de manière à faire face audit film barrière.

Fig. 1

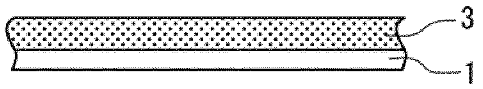


Fig. 2

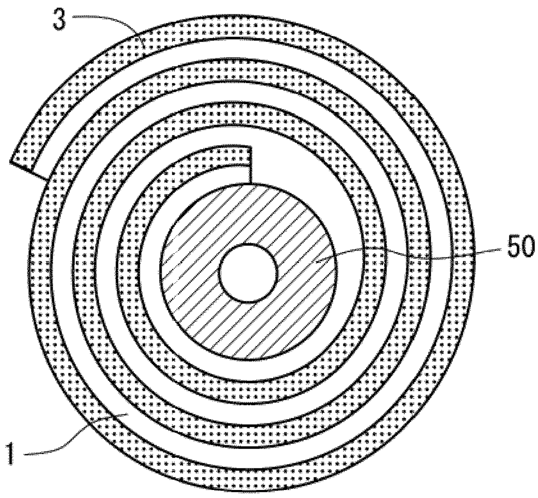


Fig. 3

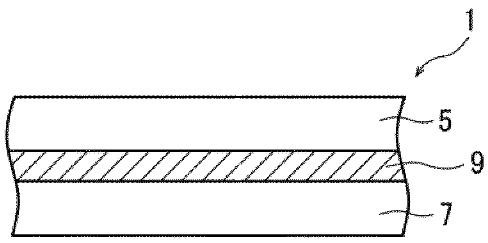


Fig. 4

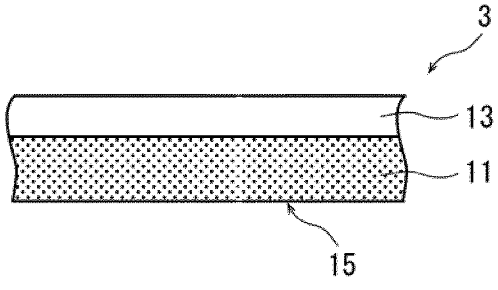

Fig. 5

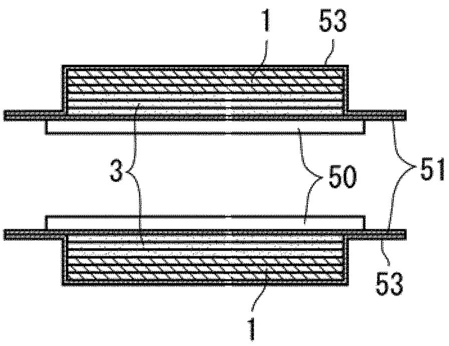


Fig. 6

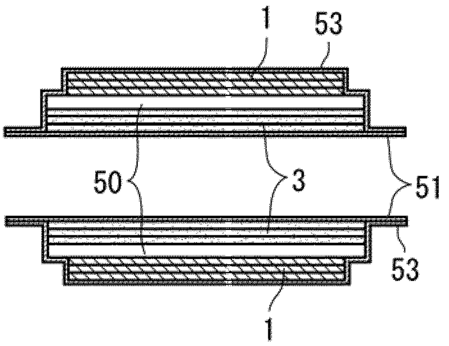

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000255579 A
- JP 2015096320 A
- JP 2014019056 A